(19) Europäisches Patentamt / European Patent Office / Office européen des brevets

(11) **EP 4 167 045 B1**

(12) **EUROPEAN PATENT SPECIFICATION**

(45) Date of publication and mention
of the grant of the patent:
**07.01.2026 Bulletin 2026/02**

(21) Application number: **21937197.8**

(22) Date of filing: **24.11.2021**

(51) International Patent Classification (IPC):
*G06F 1/02* (2006.01)   *H03K 3/38* (2006.01)
*H03K 5/1252* (2006.01)   *G06N 10/40* (2022.01)
*G06N 10/20* (2022.01)   *G06F 1/03* (2006.01)
*H03H 17/04* (2006.01)

(52) Cooperative Patent Classification (CPC):
**G06F 1/022; G06F 1/0321; G06N 10/20;
G06N 10/40; H03K 3/38; H03K 5/1252;**
H03H 17/04; Y02P 90/02

(86) International application number:
**PCT/CN2021/132801**

(87) International publication number:
**WO 2023/024291 (02.03.2023 Gazette 2023/09)**

(54) **SIGNAL CONTROL SYSTEM AND METHOD FOR QUANTUM COMPUTATION, AND WAVEFORM CALIBRATION CIRCUIT**

SYSTEM UND VERFAHREN ZUR STEUERUNG EINES SIGNALS VON QUANTENBERECHNUNG UND WELLENFORMKALIBRIERUNGSSCHALTUNG

SYSTÈME ET PROCÉDÉ DE COMMANDE DE SIGNAL POUR CALCUL QUANTIQUE, ET CIRCUIT D'ÉTALONNAGE DE FORME D'ONDE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **26.08.2021 CN 202110988046**

(43) Date of publication of application:
**19.04.2023 Bulletin 2023/16**

(73) Proprietors:
• **Shenzhen Tencent Computer Systems Company
Limited
Shenzhen, Guangdong 518057 (CN)**
• **INSTITUTE OF SOFTWARE CHINESE ACADEMY
OF SCIENCES
Beijing 100190 (CN)**

(72) Inventors:
• **LI, Riling
Beijing 100190 (CN)**
• **ZHANG, Mengyu
Shenzhen, Guangdong 518057 (CN)**
• **ZHANG, Zhenxing
Shenzhen, Guangdong 518057 (CN)**
• **YING, Shenggang
Beijing 100190 (CN)**
• **ZHANG, Shengyu
Shenzhen, Guangdong 518057 (CN)**

(74) Representative: **Novagraaf International SA
Chemin de l'Echo 3
1213 Onex, Geneva (CH)**

(56) References cited:
CN-A- 103 018 701      CN-A- 113 011 591
US-A- 5 805 479       US-A1- 2020 034 736

• ROL M A ET AL: "Time-domain characterization
and correction of on-chip distortion of control
pulses in a quantum processor", APPLIED
PHYSICS LETTERS, AMERICAN INSTITUTE OF
PHYSICS, 2 HUNTINGTON QUADRANGLE,
MELVILLE, NY 11747, vol. 116, no. 5, 3 February
2020 (2020-02-03), XP012244278, ISSN:
0003-6951, [retrieved on 20200203], DOI: 10.1063/
1.5133894

• **YANG YUCHEN ET AL: "An FPGA-Based Low Latency AWG for Superconducting Quantum Computers", 2021 IEEE INTERNATIONAL INSTRUMENTATION AND MEASUREMENT TECHNOLOGY CONFERENCE (I2MTC), IEEE, 17 May 2021 (2021-05-17), pages 1 - 6, XP033934666, DOI: 10.1109/I2MTC50364.2021.9460084**

## Description

### RELATED APPLICATION

The present disclosure claims priority to Chinese Patent Application No. 202110988046.9, filed on August 26, 2021 and entitled "QUBIT CONTROL SYSTEM AND WAVEFORM CALIBRATION CIRCUIT".

### FIELD OF THE TECHNOLOGY

The present disclosure relates to the technical field of computers and digital signal processing, and in particular, to a system and a method for controlling a signal in quantum computing, and a waveform calibration circuit.

### BACKGROUND OF THE DISCLOSURE

Waveform calibration refers to calibration against waveform distortion, and thereby a desired waveform is outputted or applied on a target.

Conventional quantum technology addresses the waveform distortion on a qubit control line in a following manner. A calibrated waveform is calculated in advance at an upper computer, for example a personal computer (PC) or a server at an upper level, then the calibrated waveform is transmitted to an arbitrary waveform generator (AWG) via a network, and the AWG generates a corresponding pulse signal according to the calibrated waveform, so as to control a qubit. As an example, document titled "Time-domain characterization and correction of on-chip distortion of control pulses in a quantum processor" by M. A. Rol et al. (Appl. Phys. Lett. 116, 054001 (2020); doi: 10.1063/1.5133894) discloses a method for sampling on-chip basband pluses used to dynamically control qubit frequency through Cryoscope. As another example, document titled "An FPGA-Based Low Latency AWG for Superconducting Quantum Computers" by Yuchen Yang et al. (2021 IEEE INTERNATIONAL INSTRUMENTATION AND MEASUREMENT TECHNOLOGY CONFERENCE (I2MTC), IEEE 17 May 2021 (2021-05-17), pages 1-6, DOI: 10.1109/I2MTC50364.2021.9460084) discloses a low-latency AWG for control and measurement of super conducting quantum computers.

The foregoing manner requires operations at the host computer, for example, invoking a process or conveying data. Accordingly, there is a large communication delay, which cannot meet a low-delay requirement in practice.

### SUMMARY

The invention is defined as set out in the independent claims. Further embodiments are depicted in the dependent claims. A system and a method for controlling a signal in quantum computing, and a waveform calibration circuit are provided according to embodiments of the present disclosure. The technical solutions are as follows.

In one aspect, a system for controlling a signal in quantum computing is provided, including: a signal source, a waveform calibration circuit, a qubit control line, and a qubit module, where: the signal source is configured to generate an original control signal; the waveform calibration circuit includes at least one infinite impulse response (IIR) digital filter, and the IIR digital filter is configured to calibrate a waveform of the original control signal to obtain a calibrated control signal; the qubit control line is configured to convey the calibrated control signal to the qubit module; the qubit module is configured to generate a qubit; and the calibrated control signal is applied on the qubit after passing the qubit control line, and is configured to control the qubit.

In another aspect, a waveform calibration circuit is provided, including at least one IIR digital filter, where: the IIR digital filter is configured to calibrate a waveform of an input signal to obtain an output signal, the output signal is calculated based on the input signal and a state value, the state value is updated each time a group of sampling points is sampled, and the group of sampling points includes multiple sampling points.

In another aspect, a method for controlling a signal in quantum computing is provided. The method is applicable to a system for controlling the signal in quantum computing, the system includes a signal source, a waveform calibration circuit, a qubit control line, and a qubit module, and the method includes: generating an original control signal by the signal source; calibrating, by the waveform calibration circuit, a waveform of the original control signal through at least one IIR digital filter in the waveform calibration circuit to obtain a calibrated control signal; conveying, by the qubit control line, the calibrated control signal to the qubit module; and generating a qubit by the qubit module; where the calibrated control signal is applied on the qubit after passing the qubit control line and is configured to control the qubit.

In another aspect, a computer-readable storage medium is provided. The storage medium stores at least one instruction, at least one program, a code set, or an instruction set, where the at least one instruction, the at least one program, the code set, or the instruction set is loaded and executed by a processor to implement the foregoing method for controlling the signal of quantum computing.

In another aspect, a computer program product or a computer program including computer instructions is provided, where the computer instructions is stored in a computer-readable storage medium, a processor of a computer device reads the computer instructions from the computer-readable storage medium and executes the computer instructions to configure the computer device to perform the foregoing method for controlling the signal of quantum computing.

The signal for controlling the qubit is pre-compensated and pre-calibrated through the IIR digital filter in the waveform calibration circuit. Thereby, after passing the qubit control line, the calibrated control signal which is accurate and desired is applied on the qubit, hence achieving precise control on the qubit. In addition, the IIR digital filter calibrates the waveform of the control signal in the waveform calibration circuit, which is a hardware circuit. Compared with waveform calibration performed by an upper computer, a communication delay due an operation at the upper computer, e.g., invoking a process and conveying data, can be avoided. Hence, the waveform calibration herein consumes less time and meets a low-delay requirement in practice.

BRIEF DESCRIPTION OF THE DRAWINGS

Figure 1 is a schematic diagram of a system for controlling a signal in quantum computing according to an embodiment of the present disclosure.

Figure 2 is a schematic diagram of an IIR filter according to an embodiment of the present disclosure.

Figure 3 is a schematic graph of local performance data of a simulated IIR digital filter according to an embodiment of the present disclosure.

Figure 4 is a schematic graph of global performance data of a simulated IIR digital filter according to an embodiment of the present disclosure.

Figure 5 is a schematic graph of experiment data of a real IIR digital filter applied in an electronic system according to an embodiment of the present disclosure.

Figure 6 is another schematic graph of local performance data of a simulated IIR digital filter according to an embodiment of the present disclosure.

Figure 7 is a flowchart of a method for controlling a signal in quantum computing according to an embodiment of the present disclosure.

DESCRIPTION OF EMBODIMENTS

Hereinafter explained are some key terms involved in the present disclosure.

1. A quantum computation (QC) refers to a scheme of using superposition and entanglement properties of quantum states in order to complete a specific computation task rapidly.

2. A superconducting quantum computing (SQC) refers to a technique route for implementing quantum computing by using the Josephson junction (JJ) which is based on the superconducting technology.

3. A quantum bit (qubit) refers to a basic unit for information storage and processing in a quantum computer. Quantum computing is essentially manipulating the qubits. In the SQC, qubits operate under ultra-low temperature, and are manipulated by applying a pulsed signal.

4. A field programmable gate array (FPGA) refer to a product developed on a basis of programmable logic devices, such as the programmable array logic (PAL), the generic array logic (GAL), and the complex programmable logic device (CPLD). The FPGA emerged as a semi-customized circuit in the field of the application specific integrated circuits (ASICs). The FPGA not only resolves the shortcomings of customized circuits, but also overcomes the limited quantity of gate circuits in traditional programmable device. The FPGA may be programmed by using the hardware programming language Verilog hardware description language (HDL) or very-high-speed integrated circuit hardware description language (VHDL).

5. A Verilog HDL refers to an HDL and is abbreviated as Verilog. The Verilog is a language that describes a structure and a behavior of digital system hardware in a textual form. It can be used to describe logical circuit diagrams, logical expressions, and logical functions implemented by digital logic systems.

6. A digital filter refers to an algorithm or apparatus formed by a digital multiplier, an adder, and a delay unit. The digital filter is configured to perform process a digital code of an inputted discrete signal, so as to change a frequency spectrum of the signal.

7. An analog filter refers to a circuit or a device that can filter analog signals or temporally continuous signals.

8. A finite impulse response digital filter (FIR DF) refers to a type of digital filters of which a unit impulse response h(n) only contains finite non-zero samples, and is abbreviated as FIR. The FIR is generally implemented as a non-recursive structure, and is thus also called a non-recursive digital filter. A typical relationship between an input signal x[n] and an output signal y[n] of the FIR is $y[n] = h[0]x[n] + h[1]x[n-1] + \cdots + h[N]x[n-N]$, where N is a length of the unit impulse response of the digital filter.

9. An infinite impulse response digital filter (IIR DF) is a counterpart of the FIR and refers to a digital filter in which a response to an inputted unit impulse signal h is an infinite sequence. The IIR DF is abbreviated as IIR, and is characterized in that an output y[n] is determined by the current and past input signal x[n] and the past output signal jointly. Generally, a mathematical relationship of the IIR is: y[n] = b[0]x[n] + b[1]x[n - 1]+ ⋯ + b[N]x[n - N] - a[1]y[n - 1] - a[2]y[n - 2]- ⋯ - a[M]y[n - M], in which previous output signals y[n -1],⋯, y[n - M] participates in the computation. Herein the "IIR digital filter" refers to the "infinite impulse response digital filter".

10. A Z channel is one of channels for manipulating physical qubits in a SQC device. The channels include an XY channel, the Z channel, a reading channel, and the like. The Z channel is configured to change a frequency of a qubit rapidly and transiently through a pulse signal, and is frequently used in quantum computing tasks.

11. Real-time feedback control is a necessary function in future programmable quantum computers. The real-time feedback control requires that, in a QC task, a classical data register can receive a result of measurement on some qubits in real time and a value in a classical register may be used to determine a subsequent operation on a qubit. Quantum data and classical data are interactive in the whole computing process.

12. Pulse distortion refers to a certain distortion of a waveform of a pulse actually applied on the qubit with respect to that of an original input pulse, which is due to an impact of an external component under room temperature (for example, due to a bandwidth of a waveform generator and high-pass filtering of a bias component), due to a component inside a dilution refrigerator (for example, due to a low-pass filter, impedance detuning, and a skin effect of coaxial cables), and due to signal wiring on a quantum chip. Calibration needs to be performed against the pulse distortion to ensure accuracy of qubit manipulation.

13. A qubit control line is configured to control a qubit. For example, the qubit control line transmits a control signal for controlling the qubit. The qubit control line may include a microwave control line (also referred to as an XY line) and a direct-current bias line (also referred to as a Z line). The microwave control line is configured to drive the qubit to transit between different energy levels. The DC bias line is configured to tune a frequency of the qubit. Herein the qubit control line includes at least the DC bias line.

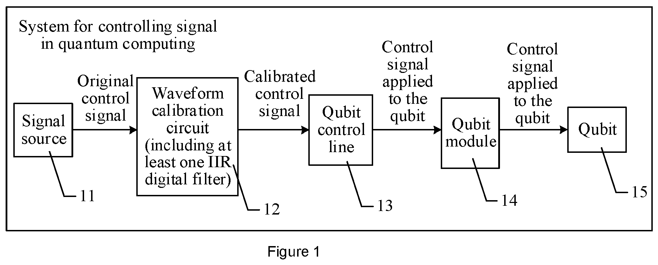

Figure 1 is a schematic diagram of a system for controlling a signal in quantum computing according to an embodiment of the present disclosure. The signal control system may include a signal source 11, a waveform calibration circuit 12, a qubit control line 13, and a qubit module 14.

The signal source 11 is configured to generate an original control signal.

The waveform calibration circuit 12 includes at least one IIR digital filter, and the IIR digital filter is configured to calibrate a waveform of the original control signal to obtain a calibrated control signal.

The qubit control line 13 is configured to convey the calibrated control signal to the qubit module 14.

The qubit module 14 is configured to generate a qubit 15.

The calibrated control signal is applied on the qubit 15 after passing the qubit control line 13, and is configured to control the qubit 15.

The original control signal refers to a signal generated by the signal source 11 for controlling the qubit 15. For example, the original control signal may be a pulse signal for adjusting a frequency of the qubit 15. A form of the original control signal is not limited herein. The original control signal may be, for example, a light signal, an electrical signal, a magnetic signal, a sound signal, or the like. In an embodiment, the original control signal is a light signal, and the signal source 11 is configured to generate a light pulse to control the qubit 15. In another embodiment, the original control signal is in an electrical signal, and the signal source 11 is configured to generate an electrical pulse to control the qubit 15.

The qubit control line 13 is configured to control the qubit 15. For example, the qubit control line 13 may adjust the frequency of the qubit 15, which is generated by the qubit module 14, through conveying a pulse signal to the qubit module 14. Optionally, the qubit control line 13 may be implemented in various forms. In an embodiment, the qubit control line 13 may be in a materialized form, such as a control line for conveying an optical pulse signal (for example, an optical fiber) or a control line for guiding an electrical pulse signal (for example, an electrical-signal wire). Alternatively, the qubit control line 13 may be in an immaterialized form, such as a channel for conveying a magnetic signal or a channel for conveying an acoustic signal, which is not limited herein. The term "convey" in embodiments of the present disclosure may be understood as conduction or propagation, for example, conduction or propagation in a materialized qubit control line (for example, the optical fiber or the electrical-signal wire), or transmission or propagation in an immaterialized qubit control line (for example, a channel).

The qubit module 14 is configured to generate qubits. For example, the qubit module 14 may generate qubits having an arbitrary particle form, such as photons or electrons.

A waveform of a pulse actually applied on the qubit 15 may distort somehow with respect to that of an original input pulse, due to an impact of an external component under room temperature (for example, due to a bandwidth of a waveform generator and high-pass filtering of a bias component), a component inside a dilution refrigerator (for example, due to a low-pass filter, impedance detuning, and a skin effect of coaxial cables), or signal wiring on a quantum chip. Hence, calibration needs to be performed against the pulse distortion to ensure accuracy of qubit manipulation. Herein terms such as "pulse distortion", "waveform distortion", "pulse waveform distortion", "nonlinear distortion", and "nonlinear aberration" are different expressions representing the same content, and a person skilled in the art can understand their content.

That is, in a case that the original control signal generated by the signal source 11 is directly applied on the qubit 15 through the qubit control line 13, a waveform corresponding to the original control signal would be distorted due to the LRC devices (i.e., an inductor, a resistor, and a capacitor) on the qubit control line 13 or other causes. Thereby, the control signal actually applied on the qubit 15 differs from the original control signal. It is thus necessary to calibrate the waveform of the original control signal generated by the signal source 11 through pre-compensation (also called pre-calibration) to obtain the calibrated control signal. The calibrated control signal passes the qubit control line 13 and then is applied on the qubit 15, so that the control signal finally applied on the qubit 15 is accurate and in line with the desired control signal. For example, the control signal finally applied on the qubit 15 is identical to the original control signal to the most extent. Hence, a precise control on the qubit 15 can be achieved.

Herein the waveform of the original control signal is calibrated by the waveform calibration circuit 12. Specifically, the waveform calibration circuit 12 includes at least one IIR digital filter, and the waveform of the original control signal is calibrated by the at least one IIR digital filter to obtain the calibrated control signal. A quantity of the IIR digital filters may be set according to an actual situation, and is not limited herein.

As an example, there is only one IIR digital filter for calibrating the waveform. An input signal of the IIR digital filter is the original control signal, and an output signal of the IIR digital filter is the calibrated control signal.

As another example, there are multiple IIR digital filters for calibrating the waveform. The multiple IIR digital filters may be connected in series, in parallel, or in hybrid series-parallel. The original control signal is converted into the calibrated control signal after being processed by the multiple IIR digital filters.

In some embodiments, a serial structure including N IIR digital filters is taken as an example, where N is an integer greater than 1 and the N IIR digital filters are sequentially connected in series. An input signal of the first IIR digital filter is the original control signal, and the first IIR digital filters the original control signal to obtain an output signal of the first IIR digital filter. The output signal of the first IIR digital filter serves as an input signal of the second IIR digital filter, and the second IIR digital filter filters the input signal of the second IIR digital filter to obtain an output signal of the second IIR digital filter. The intermediate filters can be deduced by analogy. An output signal of the $(N-1)^{th}$ IIR digital filter serves as an input signal of an $N^{th}$ IIR digital filter, and the $N^{th}$ IIR digital filter filters the input signal of the $N^{th}$ IIR digital filter to obtain an output signal of the $N^{th}$ IIR digital filter. The output signal of the $N^{th}$ IIR digital filter is the calibrated control signal.

As an example, a serial structure of four IIR digital filters is utilized for calibration against the waveform distortion in the Z channel. The signal source 11 generates the original control signal, and the original control signal is configured to adjust a frequency of the qubit 15. The waveform calibration circuit 12 includes the four IIR digital filters which are connected in series. An input signal of the first IIR digital filter is the original control signal, and the first IIR digital filter filters the original control signal to obtain an output signal of the first IIR digital filter. The output signal of the first IIR digital filter serves as an input signal of the second IIR digital filter, and the second IIR digital filter filters the input signal of the second IIR digital filter to obtain an output signal of the second IIR digital filter. The output signal of the second IIR digital filter serves an input signal of the third IIR digital filter, and the third IIR digital filter filters the input signal of the third IIR digital filter to obtain an output signal of the third IIR digital filter. The output signal of the third IIR digital filter serves an input signal of the fourth IIR digital filter, and the fourth IIR digital filter filters the input signal of the fourth IIR digital filter to obtain an output signal of the fourth IIR digital filter. The output signal of the fourth IIR digital filter is the calibrated control signal. Afterwards, the calibrated control signal passes the qubit control line 13 (optionally, configured as the Z line or the direct-current bias line) and then is applied on the qubit 15, in order to adjust the frequency of the qubit 15.

In some embodiments, the waveform calibration circuit 12 is an FPGA. Since the FPGA has a characteristic of low delay, a waveform calibration system directly implemented thereon can reduce time consumption of the waveform calibration and achieve a low delay. Experiments have revealed that the waveform calibration circuit 12 implemented through an FPGA can control the delay to be within 40 ns, which meets a delay requirement for controlling qubits and serve as a basis for implementing classical-quantum hybrid computing architecture having real-time feedback. Specifically, a future input signal is unpredictable (i.e., may be determined by a result of a current measurement on a quit) in a real-time classical-quantum interaction system. Hence, the IIR digital filter has a high requirement of a low delay. The IIR digital filter implemented on the FPGA can meet such low-delay requirement of a quantum interactive system.

Optionally, the FPGA has eight channels, and each of the channels is capable to include up to four IIR digital filters. Therefore, a single FPGA can accommodate up to $8 \times 4 = 32$ IIR digital filters. It is assumed that the serial structure of four IIR digital filters is used for calibration against waveform distortion in the Z-channel, that is, each qubit requires four IIR digital filters. In such case, the single FPGA can meet a usage requirement of eight qubits and achieve real-time (i.e., having a delay of only a few tens of ns) calibration against the wave form distortion under a high density of channels (i.e., multiple filters in a single FPGA).

In some embodiments, the waveform calibration circuit 12 may alternatively adopt another form of hardware integration in the ASIC field, for example, adopts the CPLD or specific customized chips, as long as the low-delay requirements can be met. The present disclosure is not limited herein.

According to technical solutions provided in embodiments of the present disclosure, the signal for controlling the qubit is pre-compensated and pre-calibrated through the IIR digital filter in the waveform calibration circuit. Thereby, after passing the qubit control line, the calibrated control signal which is accurate and desired is applied on the qubit, hence achieving precise control on the qubit. In addition, the IIR digital filter calibrates the waveform of the control signal in the waveform calibration circuit, which is a hardware circuit. Compared with waveform calibration performed by an upper computer, a communication delay due an operation at the upper computer, e.g., invoking a process and conveying data, can be avoided. Hence, the waveform calibration herein consumes less time and meets a low-delay requirement in practice.

In some embodiments, each IIR digital filter in the waveform calibration circuit 12 is configured to compute an output signal thereof according to an input signal and a state thereof. The input signal of said IIR digital filter may be the original control signal, or may be an output signal of one or more other IIR digital filters connected thereto. Details may refer to embodiments in the foregoing description and are not repeated herein. A filtering process in the IIR digital filter may be as follows. A series of data points (herein called "sampling points") are sampled from the input signal based on a specific sampling frequency. A value corresponding to each sampling point in the output signal is calculated according to a value corresponding to said sampling point in the input signal and a value of the state of the IIR digital filter.

In principle, the state of the IIR digital filter should be sequentially updated along with each sampling points. That is, the value corresponding to each sampling point in the output signal is calculated based on the value corresponding to said sampling point in the input signal and a value of the state corresponding to the sampling point. In order to reduce time consumed by the waveform calibration, values corresponding to multiple sampling points in the output signal is required to be simultaneously in each beat (for example, 10 ns) at the waveform calibration circuit 12 (for example, the FPGA). The state of the IIR digital filter is iteratively updated for each sampling point, that is, a value of the state corresponding to a current sampling point needs to be calculated based on a value of the state corresponding to the previous sampling point(s). Hence, the values of the state cannot be simultaneously calculated in parallel for multiple sampling points. In a case that the state is sequentially updated with each sampling point, the values corresponding to the multiple sampling points in the output signal cannot be simultaneously computed in each beat. For example, values corresponding to 20 sampling points in the output signal need to be simultaneously calculated in each beat. In a case that the state is sequentially updated with the sampling points, 20 operations need to be performed in sequence to calculate the value of the state corresponding to each sampling point. Such process would consume much longer than 10 ns.

In embodiments of the present disclosure, the above issue is addressed, and the values corresponding to the multiple sampling points in the output signal are simultaneously computed in each beat. The state of the IIR digital filter is updated each time a group of sampling points are sampled, and each group of sampling points includes multiple sampling points. That is, the multiple sampling points in the same group correspond to the same state value (i.e., the value of the state), and such value is configured to represent the state values of the multiple consecutive sampling points approximately. It is appreciated that in comparison with updating the state value point-by-point, updating the state value group-by-group reduces a quantity of computing operations on the state and reduces time consumed by processing of the IIR digital filter to a great extent. Thereby, the values corresponding to the multiple sampling points can be simultaneously calculated in each beat.

Optionally, groups of sampling points may include identical or different quantities of sampling points. In order to simplify computation, each group of sampling points includes the same quantity of sampling points, that is, k sampling points, where k is an integer greater than 1. A value of k is negatively correlated with time consumed by computation of the IIR digital filter, and is negatively correlated with accuracy of the IIR digital filter. That is, a larger k indicates that more sampling points share the same state, which in one aspect reduces a quantity of operations for computing the state value and reduces time consumed by computation of the IIR digital filter, and in another aspect reduces the accuracy of the IIR digital filter. Conversely, a smaller k indicates that less sampling points share the same state, which helps improve the accuracy of the IIR digital filter while increases the quantity of operations for computing the state value and thereby increases the time consumed by computation= of the IIR digital filter. Therefore, requirements of time consumption and accuracy of the computation should be comprehensively considered to determine an appropriate k when designing the IIR digital filter.

In some embodiments, k is within a range of [5, 10], that is, a quantity of sampling points in each group ranges from 5 to 10. For example, experiments reveal that each group including ten sampling points is capable to meet the requirements on accuracy and real-time performance for calibration against waveform distortion in the Z-channel. It is appreciated that a smaller k may be used, for example, each group includes five sampling points, in a case that the accuracy needs to be improved in some scenarios. The present disclosure is not limited thereto. In an embodiment, setting k within [5, 10] renders the IIR digital filter applicable to a scenario of waveform calibration on the control signal for the qubit, while meeting the requirements on accuracy and real-time performance of the waveform calibration scenario. Experiment data corresponding to each group including ten sampling points and each group including five sampling points are respectively illustrated in following description.

In some embodiments, each IIR digital filter in the waveform calibration circuit 12 is configured to calculate a weighted sum of an input signal thereof and a state value thereof, so as to calculate the output signal thereof. The weights corresponding to the input signal and the state value, respectively, may be preset.

In some embodiments, the IIR digital filter computes the value which is in the output signal and corresponds to a sampling point in a following manner. The state value corresponding to the $i^{th}$ group of sampling points is calculated according to an average of values which are in the input signal and correspond to sampling points, respectively, in the $i^{th}$ group of sampling points and a state corresponding to an $(i-1)^{th}$ group of sampling points, where i is a positive integer. For each sampling point in the $i^{th}$ group, the value corresponding to said sampling point in the output signal is calculated according to the value corresponding to the sampling point in the input signal and the state value corresponding to the $i^{th}$ group of sampling points. Optionally, after the average of the values corresponding to the sampling points, respectively, in the $i^{th}$ group in the input signal is calculated, a weighted sum of such average and the state value corresponding to the $(i-1)^{th}$ group of sampling points is calculated to obtain the state corresponding to the $i^{th}$ group of sampling points. Afterwards, for each sampling point in the $i^{th}$ group, a weighted sum of the value corresponding to said sampling point in the input signal and the state value corresponding to the $i^{th}$ group is calculated to obtain the value corresponding to said sampling point in the output signal. According to the foregoing description, the multiple sampling points in the same group share the same approximate state value, thereby reducing a quantity of operations for updating the state value and reducing time consumed by the computation. In addition, the values which are in the output signal and correspond to the multiple sampling points, respectively, in the $i^{th}$ group may be simultaneously calculated (or calculated in parallel), thereby reducing time consumed by computing the output signal.

In some embodiments, the computation in the IIR digital filter is implemented through the pipeline technology to improve the parallelism and further reduce the time consumption. The pipeline technology refers to implementation of quasi-parallel processing in which operations belonging to different parts are performed in an overlapping manner for a computation task.

In some embodiments, the IIR digital filter is implemented through a pipeline having three stages, which include a first-stage pipeline, a second-stage pipeline, and a third-stage pipeline. The first-stage pipeline is configured to perform preliminary processing on the values which are in the input signal and correspond to the sampling points, respectively, of the $i^{th}$ group, so as to prepare for calculation of the average and the stage value in the next stage. For example, the first-stage pipeline is configured to calculate a sum of the values corresponding to the sampling points of the $i^{th}$ group. The second-stage pipeline is configured to calculate the average of the values corresponding to the sampling points of the $i^{th}$ group in the input signal according to a result of the processing in the first-stage pipeline, and calculate the state value corresponding to the $i^{th}$ group of sampling points. For example, the second-stage pipeline is configured to calculate the average of the values corresponding to the sampling points of the $i^{th}$ group in the input signal according to the sum of these values, and calculate the state value corresponding to the $i^{th}$ group according to the such average and the state value corresponding to the $(i-1)^{th}$ group of sampling points. The third-stage pipeline is configured to calculate a value which is in the output signal and corresponds to each sampling point of the $i^{th}$ group according to the value corresponding to said sampling point in the input signal and the state value corresponding to the $i^{th}$ group. Time consumption of calculation in each stage of the pipeline is approximately one beat (i.e., 10 ns). In case of not using the pipeline, each round of computation would consume at least three beats (i.e., 30 ns). One round of computation can be implemented in each beat through using the pipeline, which further reduces a delay of the IIR digital filter.

Hereinafter illustrated is a process of deriving equations concerning technical solutions of the present disclosure.

A following step response function needs to be implemented for calibration against pulse waveform distortion due to a single RLC device.

$$y(t) = g\left(1 + Ae^{-\frac{t}{\tau}}\right)u(t)$$

The above function is continuous and corresponds to an analog filter. The parameters g, A, and $\tau$ are coefficients preset or determined through experiments. Generally, there is g = 1, and u(t) is a step function. The system function H(z) of the IIR digital filter is obtained according to a system function H(s) of the analog filter through the matched Z-transform method. An expression of the system function H(z) is as follows.

$$H(z) = \frac{B(z)}{A(z)} = \frac{b_0 + b_1 z^{-1} + b_2 z^{-2} + \cdots + b_N z^{-N}}{1 + a_1 z^{-1} + \cdots + a_M z^{-M}}$$

Then, coefficients $b_0, b_1, ..., b_N$ and $a_1, ..., a_M$ of the IIR digital filter is correspondingly obtained from the above function. H(z) is the system function that describes the digital filter on the z-domain (since the z-transform is required to transform the system function of the analog filter to that of the digital filter), and represents the complete characteristics of the filter. z represents the z-domain (i.e., polar coordinates on a complex plane). B(z) and A(z) correspond to filter coefficients $b_i$ and $a_i$, respectively, which are used in a subsequent step.

At present, the waveform calibration system involves only first-order IIR digital filters (because a multi-order IIR digital filter can be decomposed into multiple first-order IIR digital filters that are connected in series and/or in parallel). Therefore, the expression of H(z) is usually in a following form.

$$H(z) = \frac{B(z)}{A(z)} = \frac{b_0 + b_1 z^{-1}}{1 + a_1 z^{-1}}$$

A transfer function corresponding to a step response $y(t) = \left(1 + Ae^{-\frac{t}{\tau}}\right)u(t)$ is as follows.

$$H(s) = \frac{1 + (A+1)s\tau}{1 + s\tau}$$

H(s) is the system function of an analog filter. s represents the s-domain or s-plane (where x, y coordinates represent real and imaginary parts, respectively). Converting the analog filter to the digital filter requires a conversion from the s-plane to the z-plane (that is, the z-transform $z = e^{sT}$, where T is a period of the sampling signal, that is, a reciprocal of a sampling frequency). Accordingly, the system function also changes from H(s) to H(z).

Therefore, an additional transfer function needs to have a following expression in order to calibrate the above H(s).

$$H(s) = \frac{1 + s\tau}{1 + (A+1)s\tau}$$

Such transfer function can be implemented through the IIR digital filter, which may be designed through the matched Z-transform method. Such method is capable to keeps the pole and the zero unchanged. The pole is $s = -1/(A+1)\tau$, and the zero is $S = -1/\tau$. Thus, the system function H(z) of the IIR digital filter is as follows.

$$H(z) = k_d \frac{1 - e^{-\frac{1}{\tau f_s}} z^{-1}}{1 - e^{-\frac{1}{(A+1)\tau f_s}} z^{-1}}$$

$k_d$ is a coefficient, $f_s$ is a sampling frequency, and e is the natural constant. A specific value of $k_d$ is obtained by setting H(z = 0) = 1. Accordingly the coefficients of the IIR digital filter designed according to the matched Z-transform method are as follows.

$b_0 = k_d$, $b_1 = -k_d p_1$, and $a_1 = -p_2$, where

$$p_1 = e^{-\frac{1}{\tau f_s}}, \quad p_2 = e^{-\frac{1}{(A+1)\tau f_s}}, \text{ and } k_d = (1 - p_2) / (1 - p_1)$$

Correspondingly, a digital form of the IIR digital filter is as follows.

$$y[n] = b_0 x[n] + b_1 x[n-1] - a_1 y[n-1].$$

The foregoing equation is transformed from the direct form I to the canonical form of the IIR digital filter, which is as follows.

$$y[n] = \alpha x[n] + \beta u[n]$$

There is $u[n] = \gamma x[n] + \delta u[n-1]$, where y[n] represents a value which is in the output signal and corresponds to the $n^{th}$ sampling point, x[n] represents a value which is in the input signal and corresponds to the $n^{th}$ sampling point, u[n] represents the state value corresponding to the $n^{th}$ sampling point, n is a positive integer, and $\alpha, \beta, \gamma,$ and $\delta$ are coefficients which can be calculated.

$\alpha, \beta,$ and $\delta$ can be calculated from according to $b_0, b_1,$ and $a_1$. Specifically, there are $\alpha = \frac{b_1}{a_1}$, $\beta\gamma = b_0 - b_1 / a_1$, and $\delta = -a_1$. It may be set that $\beta = 1$ and $\gamma = b_0 - b_1 / a_1$ for convenience.

It is noted that the canonical form is used to extract the recursive part u[n] from y[n], and u[n] represents the state of the IIR digital filter. Hence, it is only necessary to average u[n]s in case of approximation is required, thereby minimizing a deviation due to approximating the input values x[n]. A reason lies in that there would be a large deviation during the approximation in case of calculating an average of x[n]s directly. It is taken as an example that the average of x[n]s is calculated every 10 sampling points. In such case, there is

$$\bar{x} = \frac{x[n] + x[n+1] + \cdots + x[n+9]}{10}$$, where the de-

viation is $\sum_{i=0}^{9} x[n+i] - \overline{x}$. The input value x[n] may jump, for example, there being a step signal, and hence there is a large direct impact (i.e., a deviation) on the output value y[n]. In comparison, when u[n]s are averaged for the approximation, the impact (i.e., the deviation) on the output value y[n] is controllable because the coefficient $\beta$ is usually small in practice. Therefore, an excessive deviation due to the jump of the input value x[n] can be avoided.

For example, 20 sampling points (or called data points) are subject to simultaneous computation when the output signal is computed in each beat. It is assumed that the data points to be calculated in a current beat correspond to y[n],y[n + 1],···,y[n + 19], respectively. In such case, y[n],y[n + 1],···,y[n + 19] can be calculated when u[n - 1] and x[n],x[n + 1],···,x[n + 19] are known. Since it is difficult to maintain each u[n] in real time (that is, to update u[n] separately for each sampling point), an average $\overline{u}$ of u[n -10],u[n - 9],···,u[n -1] rather than u[n -1] is used when calculating y[n],y[n + 1],···,y[n + 19]. Hence, only an average of the immediately previous 10 pieces of data u needs to be maintained for each beat. Since the averaged u[n] is obtained every 10 points, a span of two adjacent u[n]s can be considered to be 10 times the original span. Hence, the sampling rate can be approximately considered to be one tenth of the original rate.

That is, an update of $f'_s = f_s / 10$ is required when calculating H(z) based on H(s).

It is assumed that the average $\overline{u}$ of u[n - 10],u[n - 9],···,u[n - 1] is currently known, and the input signal of the current beat is x[n],x[n + 1],···,x[n + 19]. In such case, y[n],y[n + 1],···,y[n + 19] corresponding to the 20 data points and the average $\overline{u}'$ of u[n + 10],u[n + 11],···,u[n + 19] needs to be calculated accordingly. A deriving process is as follows.

It is assumed that there is

$$u_1 = \frac{u[n] + u[n+1] + \cdots + u[n+9]}{10},$$

$$u_2 = \frac{u[n+10] + u[n+11] + \cdots + u[n+19]}{10}, \text{ and}$$

$\overline{u}'$ = $u_2$. Hence, there is

$$u_1 = \frac{\gamma(x[n] + x[n+1] + \cdots + x[n+9]) + 10\delta\overline{u}}{10}$$

and

$$u_2 = \frac{\gamma(x[n+10] + x[n+11] + \cdots + x[n+19]) + 10\delta u_1}{10}$$

.

In a range of $0 \le i \le 9$, there is y[n + i] = $\alpha$x[n + i] + $\beta u_1$ and y[n + i + 10] = $\alpha$x[n + i + 10] + $\beta u_2$.

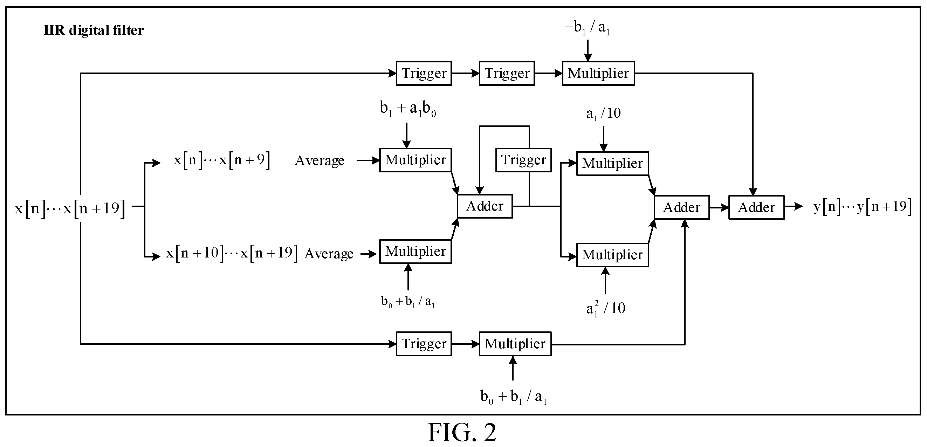

In order to adapt to a main frequency of 100 MHz, the three-stage pipeline method is used as follows. In a first beat, intermediate results of x[n]+x[n+1]+···+x[n+9] and x[n + 10] + x[n + 11]+ ··· + x[n + 19] are calculated. In the second beat, $u_1$ and $u_2$ are calculated. In the second beat, y[n],y[n + 1],···,y[n + 19] is calculated. It is appreciated that some intermediate results need to be stored in registers for smooth operation of the entire pipeline. Figure 2 shows a schematic diagram of the entire pipeline in an embodiment. In the first beat, a sum corresponding to x[n] + x[n + 1] + ··· + x[n + 9] and a sum corresponding to x[n + 10] + x[n + 11] + ··· + x[n + 19] are calculated simultaneously. In the second beat, an average corresponding to x[n] + x[n + 1] + ··· + x[n + 9] and an average corresponding to the average of x[n + 10]+x[n + 11]+ ··· + x[n + 19] are calculated based on the sums obtained in the first beat, then a weighted sum of x [n] + x[n + 1] + ··· + x[n + 9] and $\overline{u}$ is calculated to obtain $u_1$, and then a weighted sum of the average corresponding to x[n+10]+x[n+11]+···+x[n+19] and $u_1$ is calculated to obtain $u_2$. In the third beat, a weighted sum of x[n] + x[n + 1] + ··· + x[n + 9] and $u_1$ is calculated, and a weighted sum of x [n + 10] + x[n + 11] + ··· + x[n + 19] and $u_2$ is calculated, so as to obtain y[n],y[n + 1],···,y[n + 19].

In addition, the averaged u[n] obtained every five data points would render the a result of the IIR digital filter more accurate that that obtained every ten data points. Correspondingly, y[n],y[n + 1],···,y[n + 19] needs to be divided into four sections in the computation, that is, into y[n],···,y[n + 4], y[n + 5],···,y[n + 9], y[n + 10],···,y[n + 14], and y[n + 15],...,y[n + 19]. $u_1$, $u_2$, $u_3$ and $u_4$ are maintained in each beat, and each $u_i$ ($1 \le i \le 4$) represents an average corresponding to five data points. Calculation of $u_1$, $u_1$, $u_3$ and $u_4$ can be obtained from the foregoing calculation of $u_1$ and $u_1$ by analogy, where the manner of calculation may be called "time-domain crossover". In addition, the sampling rate in such case is reduced by a factor of 5 when calculating H(z) based on H(s), that is, there is $f''_s = f_s / 5$.

Optionally, fixed-point calculation is used in the whole process. Using the fixed-point numbers is advantageous in high precision, a large bit width, and stable operation, while a numerical representation range is limited. Each first-order IIR digital filter has a delay of three beats (i.e., 30 ns). L first-order IIR digital filters has a total delay of 30L ns when being connected in series, and still has total delay of 30 ns when being connected in parallel (not including the additional one beat for inputting data).

In addition, since the FPGA resources at present support appropriate expansion of the bit width of the intermediate data, using floating-point numbers can also achieve data precision comparable to that of fixed-point numbers (as long as the bit width of mantissa is close to the bit width of a fixed-point number). The numerical representation range of floating-point numbers is much larger than that of fixed-point numbers, and hence has incomparable flexibility in view of the fixed-point numbers and may be more suitable for various experimental environments in the future. At present, there is no means of using an intellectual property core concerning floating-point numbers directly in a filter. Hence, representation and computation based on floating-point numbers may require independent programming when being implemented.

Herein the waveform calibration system may be implemented on the Intel Stratix-10 FPGA through the Verilog HDL. Each FPGA has a total of eight channels, and each channel has four first-order IIR digital filters. Experiments and measurements reveal that each channel consumes merely 2% of the overall logic elements of the FPGA, which indicates a low resource consumption. The logic element refers to a basic resource unit of the FPGA, and can be used to implement logic of basic operations such as multiplication, addition, and a multiplexer. During synthesis in hardware programming, electronic design automation (EDA) software gives the consumption of the logic elements. Generally, a system is in a safe level as long as consuming no more than 80% of the total logic elements of the FPGA chip. Herein each channel consumes 2%, and eight channels consume about 16% in total.

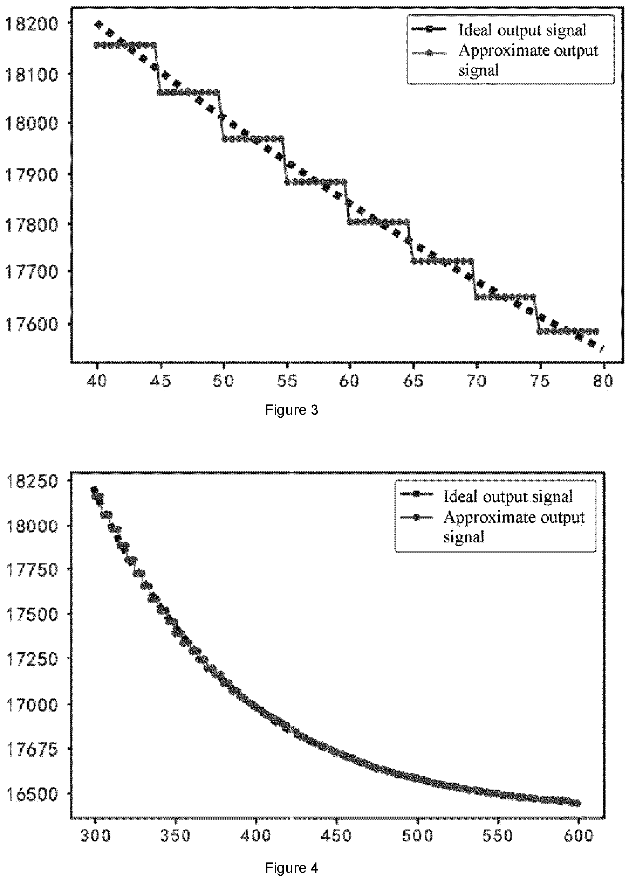

The IIR digital filter is simulated through Python (a computer programming language) and runs in an actual electronic system connected to an oscilloscope, and all experiments show that the accuracy can reach 99.9%. Figure 3 shows local performance data of a simulated IIR digital filter in Python. Figure 4 shows local performance data of the simulated IIR digital filter. In Figure 3 and Figure 4, the light-shade line represents a simulated approximate output signal (a predicted result in the oscilloscope), the dark-shade line is an ideal output signal (a result which is accurately calculated without approximation), the abscissa represents a sequential number of sampling points, and the ordinate represents a simulated value corresponding to each sampling point on the waveform. The experiment reveals that a deviation between the approximate output signal and the ideal output signal is less than one thousandth, approximately $\leq 5/18000$.

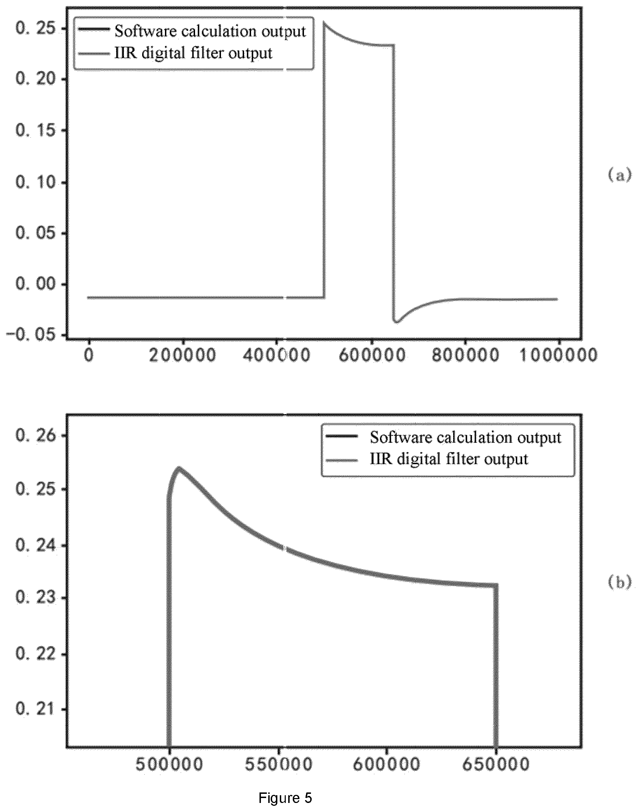

Results of experiments on an actual electronic system are further provided, where a square wave is calibrated. A result of the calibration is first calculated through software and then directly uploaded to hardware for output. The square wave is further uploaded to the hardware and calibrated through the designed IIR digital filter, and a result is also outputted. Data of the two outputted waveforms acquired by the oscilloscope are shown in Figure 5, where the subfigure (a) in Figure 5 is a schematic diagram of the global performance data, and the subfigure (b) is a schematic diagram of the local performance data. The light-shade line represents the output of the IIR digital filter, and the dark-shade line represents the output calculated through software. The output of the IIR digital filter is very accurate and approximates the ideal output signal well (that is, the output calculated through software), and it is obvious that the two lines are basically coincident in the subfigures.

The foregoing FPGA-based on-chip system for fast waveform calibration is capable to perform calibration with high precision against the signal distortion due to various LRC devices on the qubit control line. Thereby, a sound foundation for real-time feedback is provided for superconducting quantum computing.

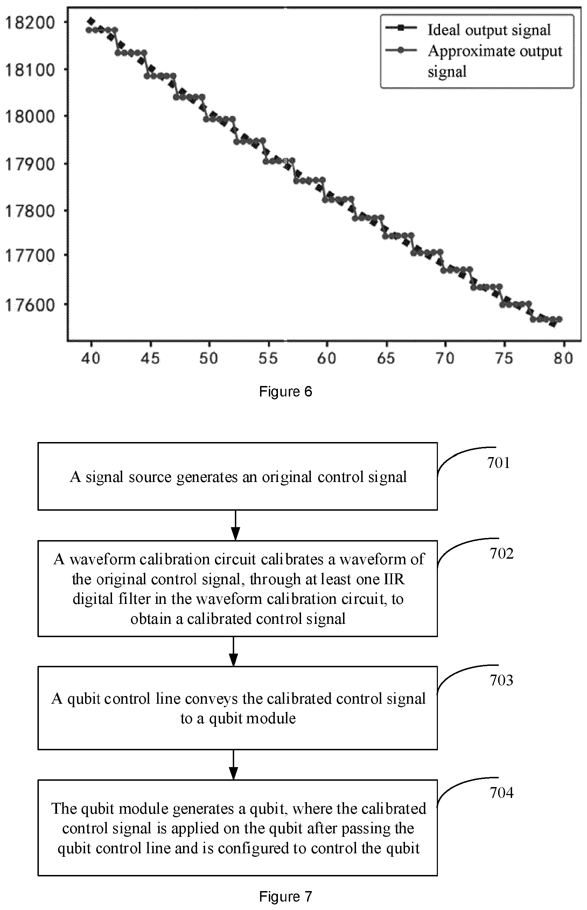

In addition, the averaged u[n] may be obtained every five data points, which would render the outputs of the IIR digital filter are more accurate. Figure 6 shows a schematic graph of a result of an experiment in which the averaged u[n] is obtained every five data points. The light-shade line is the simulated approximate output signal, the dark-shade line is the ideal output signal, the abscissa represents a sequential number of sampling points, and the ordinate represents a simulated value corresponding to each sampling point on the waveform.

A waveform calibration circuit is further provided according to an embodiment of the present disclosure. The waveform calibration circuit includes at least one IIR digital filter. The IIR digital filter is configured to calibrate a waveform of an input signal to obtain an output signal, where the output signal is computed according to the input signal and a state value. Optionally, the state is updated each time a group of sampling points is sampled, and each group of sampling points includes multiple sampling points.

In some embodiments, the IIR digital filter is configured to calculate the state value corresponding to the $i^{th}$ group of sampling points according to an average of values which are in the input signal and correspond to sampling points, respectively, in the $i^{th}$ group and the state value corresponding to the $(i-1)^{th}$ group of sampling points, where i is a positive integer, and calculate a value which is in the output signal and corresponds to each sampling point in the $i^{th}$ group according to a value which is in the input signal and corresponds to said sampling point and the state value corresponding to the $i^{th}$ group.

In some embodiments, the IIR digital filter is implemented through a pipeline having three stages. A first stage of the pipeline is configured to perform preliminary processing on the values which are in the input signal and correspond to the sampling points, respectively, in the $i^{th}$ group. A second stage of the pipeline is configured to calculate an average of the values which are in the input signal and correspond to the sampling points, respectively, in the $i^{th}$ group according to a result of the processing of the first-stage pipeline, and calculate the state value corresponding to the $i^{th}$ group according to the average of values which are in the input signal and correspond to the sampling points in the $i^{th}$ group and the state value corresponding to the $(i-1)^{th}$ group. A third stage of the pipeline is configured to calculate the output signal which is in the output signal and corresponds to each sampling point in the $i^{th}$ group according to the value which is in the input signal and corresponds to said sampling point and the state value corresponding to the $i^{th}$ group.

In some embodiments, each group of sampling points includes k sampling points, and k is an integer greater than 1.

In some embodiments, the waveform calibration circuit is an FPGA.

Illustration of the waveform calibration circuit may refer to the description of the foregoing embodiments above, and details not repeated herein. In addition, the foregoing embodiments mainly take application of the waveform calibration circuit in the qubit control system as an example when explaining an operation principle of the waveform calibration circuit. The waveform calibration circuit is also applicable to other application scenarios which require waveform calibration, and the application scenarios are not limited herein.

Hereinafter illustrated are method embodiments of the present disclosure, which can be implemented through the system provided herein. Details not disclosed in the method embodiments may refer to the system embodiments of the present disclosure.

Referring is made to Figure 7. A method for controlling a signal in quantum computing is further provided according to an embodiment of the present disclosure. The method is applicable to a system for controlling a signal in quantum computing, and the system includes a signal source, a waveform calibration circuit, a qubit control line, and a qubit module. Illustration of the system may refer to the foregoing embodiments, and details are not repeated herein. The method may include following steps 701 to 704.

In step 701, the signal source generates an original control signal.

In step 702, the waveform calibration circuit calibrates a waveform of the original control signal, through at least one IIR digital filter in the waveform calibration circuit, to obtain a calibrated control signal.

In step 703, the qubit control line conveys the calibrated control signal to the qubit module.

In step 704, the qubit module generates a qubit. The calibrated control signal is applied on the qubit after passing the qubit control line, and is configured to control the qubit.

In some embodiments, the IIR digital filter calculates an output signal of the IIR digital filter according to an input signal of the IIR digital filter and a state of the IIR digital filter. The state of the IIR digital filter is updated each time a group of sampling points is sampled, and each group of sampling points includes multiple sampling points.

In some embodiments, the IIR digital filter calculates the state value corresponding to the $i^{th}$ group of sampling points according to an average of values which are in the input signal and correspond to sampling points, respectively, in the $i^{th}$ group and the state value corresponding to the $(i-1)^{th}$ group of sampling points, where i being a positive integer, and calculates a value which is in the output signal and corresponds to each sampling point in the $i^{th}$ group according to an value which is in the input signal and corresponds to said sampling point and the state value corresponding to the $i^{th}$ group.

In some embodiments, the IIR digital filter is implemented through a pipeline having three stages. A first stage of the pipeline is configured to perform preliminary processing on the values which are in the input signal and correspond to the sampling points, respectively, in the $i^{th}$ group. A second stage of the pipeline is configured to calculate an average of the values which are in the input signal and correspond to the sampling points, respectively, in the $i^{th}$ group according to a result of the processing of the first-stage pipeline, and calculate the state value corresponding to the $i^{th}$ group according to the average of values which are in the input signal and correspond to the sampling points in the $i^{th}$ group and the state value corresponding to the $(i-1)^{th}$ group. A third stage of the pipeline is configured to calculate the output signal which is in the output signal and corresponds to each sampling point in the $i^{th}$ group according to the value which is in the input signal and corresponds to said sampling point and the state value corresponding to the $i^{th}$ group.

In some embodiments, each group of sampling points includes k sampling points, and k is an integer greater than 1.

In some embodiments, each group of sampling points includes sampling points of which a quantity ranges from 5 to 10.

In some embodiments, a canonical form of the IIR digital filter is $y[n] = \alpha x[n] + \beta u[n]$, where $u[n] = \gamma x[n] + \delta u[n-1]$, $y[n]$ represents the value which is in the output signal and corresponds to the $n^{th}$ sampling point, $x[n]$ represents the value which is in the input signal and corresponds to the $n^{th}$ sampling point, $u[n]$ represents a state value corresponds to the $n^{th}$ sampling point, n is a positive integer, and $\alpha$, $\beta$, $\gamma$, and $\delta$ coefficients which is computable.

In some embodiments, a direct form I of the IIR digital filter is $y[n] = b_0 x[n] + b_1 x[n-1] - a_1 y[n-1]$, where $b_0$

$= k_d$, $b_1 = -k_d p_1$, $a_1 = -p_2$, $p_1 = e^{-\frac{1}{\tau f_s}}$, $p_2 = e^{-\frac{1}{(A+1)\tau f_s}}$, $k_d$

$= (1 - p_2) / (1 - p_1)$, e is a natural constant, $f_s$ is a sampling frequency, $\tau$ is a preset coefficient, and the direct form 1 is converted into the canonical form through $\alpha = \frac{b_1}{a_1}$, $\beta\gamma =$

$b_0 - b_1 / a_1$, and $\delta = -a_1$.

In some embodiments, a system function H(z) of the IIR digital filter is $H(z) = k_d \dfrac{1 - e^{-\frac{1}{\tau f_s}} z^{-1}}{1 - e^{-\frac{1}{(A+1)\tau f_s}} z^{-1}}$, where the system function H(z) is obtained by converting a system function H(s) of an analog filter through a matched Z-transform method, $H(s) = \dfrac{1 + s\tau}{1 + (A+1)s\tau}$ , s represents an s-domain, z represents a z-domain, and A is a preset coefficient.

In some embodiments, the waveform calibration circuit is an FPGA.

In some embodiments, the FPGA has eight channels, each of which includes no more than four IIR digital filters.

According to technical solutions in embodiment of the present disclosure, the signal for controlling the qubit is pre-compensated and pre-calibrated through the IIR digital filter in the waveform calibration circuit. Thereby, after passing the qubit control line, the calibrated control signal which is accurate and desired is applied on the qubit, hence achieving precise control on the qubit. In addition, the IIR digital filter calibrates the waveform of the control signal in the waveform calibration circuit, which is a hardware circuit. Compared with waveform calibration performed by an upper computer, a communication delay due an operation at the upper computer, e.g., invoking a process and conveying data, can be avoided. Hence, the waveform calibration herein consumes less time and meets a low-delay requirement in practice.

A computer-readable storage medium is further provided according to an embodiment of the present disclosure. The computer-readable storage medium stores at least one instruction, at least one program, a code set, or an instruction set, and the at least one instruction, the at least one program, the code set, or the instruction set when loaded and executed by a processor implements the method for controlling the signal in quantum computing according to the foregoing method embodiments.

Optionally, the computer-readable storage medium may include: a read-only memory (ROM), a RAM, a solid state drive (SSD), an optical disc, or the like. The RAM may include a resistance random access memory (ReRAM) or a dynamic random access memory (DRAM).

A computer program product is further provided according to an embodiment of the present disclosure. The computer program includes at least one instruction, at least one program, a code set, or an instruction set, and the at least one instruction, the at least one program, the code set, or the instruction set when loaded and executed by a processor implements the method for controlling the signal in quantum computing according to the foregoing method embodiments.

Optionally, the foregoing computer program product (or the at least one instruction, the at least one program, the code set, or the instruction set) may be executed by a computer device. For example, the computer device may be a classic computer such as a PC. The computer device executes the computer program product to control each piece of physical hardware (for example, the signal source, the waveform calibration circuit, the qubit control line, and the qubit module) in the system for controlling the signal in quantum computing. Thereby, the foregoing method for controlling the signal in quantum computing is implemented.

**Claims**

1. A system for controlling a signal in quantum computing, comprising a signal source (11), a waveform calibration circuit (12), a qubit control line (13), and a qubit module (14), wherein:

   the signal source (11) is configured to generate an original control signal;
   the waveform calibration circuit (12) comprises at least one infinite impulse response, IIR, digital filter, and the IIR digital filter is configured to calibrate a waveform of the original control signal to obtain a calibrated control signal;
   the qubit control line (13) is configured to convey the calibrated control signal to the qubit module (14);
   the qubit module (14) is configured to generate a qubit (15); and
   the calibrated control signal is applied on the qubit (15) after passing the qubit control line (13), and is configured to control the qubit (15); wherein:
   the IIR digital filter is configured to compute an output signal of the IIR digital filter according to an input signal of the IIR digital filter and a state value of the IIR digital filter; wherein the input signal is the original output signal or through one or more other IIR digital filters filtered original control signal;
   and
   the state value of the IIR digital filter is updated each time a group of sampling points is sampled, and each group of sampling points comprises a plurality of sampling points;
   **characterized in that** the IIR digital filter is configured to:

   calculate the state value corresponding to the $i^{th}$ group of sampling points according to:

   an average of values which are in the input signal and correspond to sampling points, respectively, in the $i^{th}$ group, and
   the state value corresponding to the $(i-1)^{th}$ group of sampling points, wherein i is a positive integer, and

   calculate a value which is in the output signal and corresponds to each sampling point in the $i^{th}$ group according to:

a value which is in the input signal and corresponds to said sampling point, and
the state value corresponding to the ith group.

2. The system according to claim 1, wherein:

the IIR digital filter is implemented through a pipeline having three stages;
a first stage of the pipeline is configured to perform preliminary processing on the values which are in the input signal and correspond to the sampling points, respectively, in the $i^{th}$ group;
a second stage of the pipeline is configured to calculate an average of the values which are in the input signal and correspond to the sampling points, respectively, in the $i^{th}$ group according to a result of the processing of the first-stage pipeline, and calculate the state value corresponding to the $i^{th}$ group according to the average and the state value corresponding to the $(i-1)^{th}$ group; and
a third stage of the pipeline is configured to calculate the output signal which is in the output signal and corresponds to each sampling point in the $i^{th}$ group according to:

the value which is in the input signal and corresponds to said sampling point, and
the state value corresponding to the $i^{th}$ group.

3. The system according to claim 1 or 2, wherein each group of sampling points comprises k sampling points, and k is an integer greater than 1.

4. The system according to any one of claims 1 to 3, wherein each group of sampling points comprises sampling points of which a quantity ranges from 5 to 10.

5. The signal control system according to any one of claims 1 to 4, wherein the waveform calibration circuit (12) is a field programmable gate array, FPGA.

6. The signal control system according to claim 5, wherein the FPGA has eight channels, each of which comprises no more than four IIR digital filters.

7. A waveform calibration circuit, comprising at least one infinite impulse response, IIR, digital filter, wherein:
the IIR digital filter is configured to calibrate a waveform of an input signal to obtain an output signal, wherein the IIR digital filter computes the output signal according to the input signal and a state value of the IIR digital filter; and

the state value of the IIR digital filter is updated each time a group of sampling points is sampled, and each group of sampling points comprises a plurality of sampling points;
**characterized in that** the IIR digital filter is configured to:

calculate a state value corresponding to the $i^{th}$ group of sampling points according to:

an average of values which are in the input signal and correspond to sampling points, respectively, in the $i^{th}$ group, and
a state value corresponding to the $(i-1)^{th}$ group of sampling points, wherein i is a positive integer, and

calculate a value which is in the output signal and corresponds to each sampling point in the $i^{th}$ group according to:

a value which is in the input signal and corresponds to said sampling point, and
the state value corresponding to the ith group.

8. The waveform calibration circuit according to claim 7, wherein:

the IIR digital filter is implemented through a pipeline having three stages;
a first stage of the pipeline is configured to perform preliminary processing on the values which are in the input signal and correspond to the sampling points, respectively, in the $i^{th}$ group;
a second stage of the pipeline is configured to calculate an average of the values which are in the input signal and correspond to the sampling points, respectively, in the $i^{th}$ group according to a result of the processing of the first-stage pipeline, and calculate the state value corresponding to the $i^{th}$ group according to the average and the state value corresponding to the $(i-1)^{th}$ group; and
a third stage of the pipeline is configured to calculate the output signal which is in the output signal and corresponds to each sampling point in the $i^{th}$ group according to:

the value which is in the input signal and corresponds to said sampling point, and
the state value corresponding to the $i^{th}$

group.

9. The waveform calibration circuit according to claim 7 or 8, wherein each group of sampling points comprises k sampling points, and k is an integer greater than 1.

10. A method for controlling a signal in quantum computing, applicable to a system for controlling a signal in quantum computing, wherein the system comprises a signal source, a waveform calibration circuit, a qubit control line, and a qubit module, and the method comprises:

generating (701) an original control signal by the signal source;
calibrating (702), by the waveform calibration circuit, a waveform of the original control signal through at least one IIR digital filter in the waveform calibration circuit to obtain a calibrated control signal;
conveying (703), by the qubit control line, the calibrated control signal to the qubit module; and
generating (704) a qubit by the qubit module;
wherein the calibrated control signal is applied on the qubit after passing the qubit control line and is configured to control the qubit;
wherein the IIR digital filter is configured to compute an output signal of the IIR digital filter according to an input signal of the IIR digital filter and a state value of the IIR digital filter, wherein the input signal is the original output signal or through one or more other IIR digital filters filtered original control signal,
and the state value of the IIR digital filter is updated each time a group of sampling points is sampled, and each group of sampling points comprises a plurality of sampling points;
wherein the IIR digital filter is configured to:

calculate the state value corresponding to the $i^{th}$ group of sampling points according to:

an average of values which are in the input signal and correspond to sampling points, respectively, in the $i^{th}$ group, and
the state value corresponding to the $(i-1)^{th}$ group of sampling points, wherein i is a positive integer, and

calculate a value which is in the output signal and corresponds to each sampling point in the $i^{th}$ group according to:

a value which is in the input signal and corresponds to said sampling point,

and
the state value corresponding to the ith group.

11. A computer-readable storage medium, storing at least one instruction, at least one program, a code set, or an instruction set, wherein:
the at least one instruction, the at least one program, the code set, or the instruction set when loaded and executed by a processor of a computer device enables the computer device to implement the method according to claim 10.

12. A computer program product, comprising at least one instruction, at least one program, a code set, or an instruction set, wherein:
the at least one instruction, the at least one program, the code set, or the instruction set when loaded and executed by a processor of a computer device enables the computer device to implement the method according to claim 10.

**Patentansprüche**

1. System zum Steuern eines Signals beim Quantencomputing, das eine Signalquelle (11), eine Wellenformkalibrierschaltung (12), eine Qubitsteuerleitung (13) und ein Qubitmodul (14) umfasst, wobei:

die Signalquelle (11) dazu ausgelegt ist, ein Originalsteuersignal zu erzeugen;
die Wellenformkalibrierschaltung (12) mindestens ein digitales Filter für eine infinite Impulsantwort, IIR, umfasst und das digitale IIR-Filter dazu ausgelegt ist, eine Wellenform des Originalsteuersignals zu kalibrieren, um ein kalibriertes Steuersignal zu erhalten;
die Qubitsteuerleitung (13) dazu ausgelegt ist, das kalibrierte Steuersignal zum Qubitmodul (14) zu übertragen;
das Qubitmodul (14) dazu ausgelegt ist, ein Qubit (15) zu erzeugen; und
das kalibrierte Steuersignal an das Qubit (15) angelegt wird, nachdem es die Qubitsteuerleitung (13) durchlaufen hat, und dazu ausgelegt ist, das Qubit (15) zu steuern;
wobei:

das digitale IIR-Filter dazu ausgelegt ist, ein Ausgangssignal des digitalen IIR-Filters gemäß einem Eingangssignal des digitalen IIR-Filters und einem Zustandswert des digitalen IIR-Filters zu berechnen;
wobei das Eingangssignal das Originalausgangssignal oder das von einem oder mehreren weiteren digitalen IIR-Filtern gefilterte Originalsteuersignal ist; und

der Zustandswert des digitalen IIR-Filters immer aktualisiert wird, wenn eine Gruppe von Abtastpunkten abgetastet wird, und jede Gruppe von Abtastpunkten eine Vielzahl von Abtastpunkten umfasst;
**dadurch gekennzeichnet, dass** das digitale IIR-Filter zu Folgendem ausgelegt ist:
Berechnen des Zustandswertes, der der i-ten Gruppe von Abtastpunkten entspricht, gemäß Folgendem:

einem Durchschnitt von Werten, die sich im Eingangssignal befinden und jeweils Abtastpunkten in der i-ten Gruppe entsprechen, und
dem Zustandswert, der der (i-1)-ten Gruppe von Abtastpunkten entspricht, wobei i eine positive Ganzzahl ist, und
Berechnen eines Wertes, der sich im Ausgangssignal befindet und jedem Abtastpunkt in der i-ten Gruppe entspricht, gemäß Folgendem:

einem Wert, der sich im Eingangssignal befindet und dem Abtastpunkt entspricht, und
dem Zustandswert, der der i-ten Gruppe entspricht.

2. System nach Anspruch 1, wobei:

das digitale IIR-Filter über eine Rohrleitung mit drei Stufen implementiert wird;
eine erste Stufe der Rohrleitung dazu ausgelegt ist, an den Werten, die sich im Eingangssignal befinden und jeweils den Abtastpunkten in der i-ten Gruppe entsprechen, eine vorläufige Verarbeitung durchzuführen;
eine zweite Stufe der Rohrleitung dazu ausgelegt ist, einen Durchschnitt der Werte zu berechnen, die sich im Eingangssignal befinden und jeweils den Abtastpunkten in der i-ten Gruppe entsprechen, gemäß einem Ergebnis des Verarbeitens der ersten Stufe der Rohrleitung und den Zustandswert, der der i-ten Gruppe entspricht, gemäß dem Durchschnitt und dem Zustandswert zu berechnen, der der (i-1)-ten Gruppe entspricht; und
eine dritte Stufe der Rohrleitung dazu ausgelegt ist, das Ausgangssignal, das sich im Ausgangssignal befindet und jedem Abtastpunkt in der i-ten Gruppe entspricht, gemäß Folgendem zu berechnen:

dem Wert, der sich im Eingangssignal befindet und dem Abtastpunkt entspricht, und
dem Zustandswert, der der i-ten Gruppe entspricht.

3. System nach Anspruch 1 oder 2, wobei jede Gruppe von Abtastpunkten k Abtastpunkte umfasst und k eine Ganzzahl größer als 1 ist.

4. System nach einem der Ansprüche 1 bis 3, wobei jede Gruppe von Abtastpunkten Abtastpunkte umfasst, deren Menge von 5 bis 10 beträgt.

5. Signalsteuersystem nach einem der Ansprüche 1 bis 4, wobei die Wellenformkalibrierschaltung (12) ein feldprogrammierbares Gatearray, FPGA, ist.

6. Signalsteuersystem nach Anspruch 5, wobei das FPGA acht Kanäle aufweist, von denen jeder nicht mehr als vier digitale IIR-Filter umfasst.

7. Wellenformkalibrierschaltung, die mindestens ein digitales Filter für eine infinite Impulsantwort, IIR, umfasst, wobei:

das digitale IIR-Filter dazu ausgelegt ist, eine Wellenform eines Eingangssignals zu kalibrieren, um ein Ausgangssignal zu erhalten, wobei das digitale IIR-Filter das Ausgangssignal gemäß dem Eingangssignal und einem Zustandswert des digitalen IIR-Filters errechnet; und
der Zustandswert des digitalen IIR-Filters immer aktualisiert wird, wenn eine Gruppe von Abtastpunkten abgetastet wird, und jede Gruppe von Abtastpunkten eine Vielzahl von Abtastpunkten umfasst;
**dadurch gekennzeichnet, dass** das digitale IIR-Filter zu Folgendem ausgelegt ist:
Berechnen eines Zustandswertes, der der i-ten Gruppe von Abtastpunkten entspricht, gemäß Folgendem:

einem Durchschnitt von Werten, die sich im Eingangssignal befinden und jeweils Abtastpunkten in der i-ten Gruppe entsprechen, und
einem Zustandswert, der der (i-1)-ten Gruppe von Abtastpunkten entspricht, wobei i eine positive Ganzzahl ist, und
Berechnen eines Wertes, der sich im Ausgangssignal befindet und jedem Abtastpunkt in der i-ten Gruppe entspricht, gemäß Folgendem:

einem Wert, der sich im Eingangssignal befindet und dem Abtastpunkt entspricht, und
dem Zustandswert, der der i-ten Gruppe entspricht.

8. Wellenformkalibrierschaltung nach Anspruch 7, wobei:

das digitale IIR-Filter über eine Rohrleitung mit drei Stufen implementiert wird;

eine erste Stufe der Rohrleitung dazu ausgelegt ist, an den Werten, die sich im Eingangssignal befinden und jeweils den Abtastpunkten in der i-ten Gruppe entsprechen, eine vorläufige Verarbeitung durchzuführen;

eine zweite Stufe der Rohrleitung dazu ausgelegt ist, einen Durchschnitt der Werte zu berechnen, die sich im Eingangssignal befinden und jeweils den Abtastpunkten in der i-ten Gruppe entsprechen, gemäß einem Ergebnis des Verarbeitens der ersten Stufe der Rohrleitung und den Zustandswert, der der i-ten Gruppe entspricht, gemäß dem Durchschnitt und dem Zustandswert zu berechnen, der der (i-1)-ten Gruppe entspricht; und

eine dritte Stufe der Rohrleitung dazu ausgelegt ist, das Ausgangssignal, das sich im Ausgangssignal befindet und jedem Abtastpunkt in der i-ten Gruppe entspricht, gemäß Folgendem zu berechnen:

dem Wert, der sich im Eingangssignal befindet und dem Abtastpunkt entspricht, und dem Zustandswert, der der i-ten Gruppe entspricht.

9. Wellenformkalibrierschaltung nach Anspruch 7 oder 8, wobei jede Gruppe von Abtastpunkten k Abtastpunkte umfasst und k eine Ganzzahl größer als 1 ist.

10. Verfahren zum Steuern eines Signals beim Quantencomputing, das auf ein System zum Steuern eines Signals beim Quantencomputing anwendbar ist, wobei das System eine Signalquelle, eine Wellenformkalibrierschaltung, eine Qubitsteuerleitung und ein Qubitmodul umfasst, und wobei das Verfahren Folgendes umfasst:

Erzeugen (701) eines Originalsteuersignals durch die Signalquelle;
Kalibrieren (702) einer Wellenform des Originalsteuersignals durch die Wellenformkalibrierschaltung über mindestens ein digitales IIR-Filter in der Wellenformkalibrierschaltung, um ein kalibrierte Steuersignal zu erhalten;
Übertragen (703) des kalibrierten Steuersignals durch die Qubitsteuerleitung zum Qubitmodul; und
Erzeugen (704) eines Qubits durch das Qubitmodul;
wobei das kalibrierte Steuersignal an das Qubit angelegt wird, nachdem es die Qubitsteuerleitung durchlaufen hat, und dazu ausgelegt ist, das Qubit zu steuern;
wobei das digitale IIR-Filter dazu ausgelegt ist, ein Ausgangssignal des digitalen IIR-Filters gemäß einem Eingangssignal des digitalen IIR-Filters und einem Zustandswert des digitalen IIR-Filters zu berechnen, wobei das Eingangssignal das Originalausgangssignal oder das von einem oder mehreren weiteren digitalen IIR-Filtern gefilterte Originalsteuersignal ist, und der Zustandswert des digitalen IIR-Filters immer aktualisiert wird, wenn eine Gruppe von Abtastpunkten abgetastet wird, und jede Gruppe von Abtastpunkten eine Vielzahl von Abtastpunkten umfasst;

wobei das digitale IIR-Filter zu Folgendem ausgelegt ist:
Berechnen des Zustandswertes, der der i-ten Gruppe von Abtastpunkten entspricht, gemäß Folgendem:

einem Durchschnitt von Werten, die sich im Eingangssignal befinden und jeweils Abtastpunkten in der i-ten Gruppe entsprechen, und
dem Zustandswert, der der (i-1)-ten Gruppe von Abtastpunkten entspricht, wobei i eine positive Ganzzahl ist, und
Berechnen eines Wertes, der sich im Ausgangssignal befindet und jedem Abtastpunkt in der i-ten Gruppe entspricht, gemäß Folgendem:

einem Wert, der sich im Eingangssignal befindet und dem Abtastpunkt entspricht, und
dem Zustandswert, der der i-ten Gruppe entspricht.

11. Computerlesbares Speichermedium, auf dem mindestens eine Anweisung, mindestens ein Programm, ein Codesatz oder ein Anweisungssatz gespeichert ist, wobei:
die mindestens eine Anweisung, das mindestens eine Programm, der Codesatz oder der Anweisungssatz, wenn sie von einem Prozessor einer Computervorrichtung geladen und ausgeführt werden, es der Computervorrichtung ermöglicht, das Verfahren nach Anspruch 10 zu implementieren.

12. Computerprogrammprodukt, das mindestens eine Anweisung, mindestens ein Programm, einen Codesatz oder einen Anweisungssatz umfasst, wobei:
die mindestens eine Anweisung, das mindestens eine Programm, der Codesatz oder der Anweisungssatz, wenn sie von einem Prozessor einer Computervorrichtung geladen und ausgeführt werden, es der Computervorrichtung ermöglicht, das Verfahren nach Anspruch 10 zu implementieren.

## Revendications

1. Système pour commander un signal pour le calcul quantique, comprenant une source de signal (11), un circuit d'étalonnage de forme d'onde (12), une ligne de commande de bit quantique (13) et un module de bit quantique (14), dans lequel :

   la source de signal (11) est configurée pour générer un signal de commande d'origine ;
   le circuit d'étalonnage de forme d'onde (12) comprend au moins un filtre numérique à réponse impulsionnelle infinie, IIR, et le filtre numérique IIR est configuré pour étalonner une forme d'onde du signal de commande d'origine afin d'obtenir un signal de commande étalonné ;
   la ligne de commande de bit quantique (13) est configurée pour acheminer le signal de commande étalonné vers le module de bit quantique (14) ;
   le module de bit quantique (14) est configuré pour générer un bit quantique (15) ; et
   le signal de commande étalonné est appliqué au bit quantique (15) après avoir traversé la ligne de commande de bit quantique (13), et est configuré pour commander le bit quantique (15) ;
   dans lequel :

      le filtre numérique IIR est configuré pour calculer un signal de sortie du filtre numérique IIR selon un signal d'entrée du filtre numérique IIR et une valeur d'état du filtre numérique IIR ; dans lequel
      le signal d'entrée est le signal de sortie d'origine ou un signal de commande d'origine filtré par un ou plusieurs autres filtres numériques IIR ; et
      la valeur d'état du filtre numérique IIR est mise à jour chaque fois qu'un groupe de points d'échantillonnage est échantillonné, et chaque groupe de points d'échantillonnage comprend une pluralité de points d'échantillonnage ;
      **caractérisé en ce que** le filtre numérique IIR est configuré pour :
      calculer la valeur d'état correspondant au $i^{\text{ème}}$ groupe de points d'échantillonnage selon :

         une moyenne des valeurs qui se situent dans le signal d'entrée et qui correspondent respectivement aux points d'échantillonnage dans le $i^{\text{ème}}$ groupe, et
         la valeur d'état correspondant au $(i\text{-}1)^{\text{ème}}$ groupe de points d'échantillonnage, où i est un entier positif, et

      calculer une valeur qui se situe dans le signal de sortie et qui correspond à chaque point d'échantillonnage dans le $i^{\text{ème}}$ groupe selon :

         une valeur qui se situe dans le signal d'entrée et qui correspond audit point d'échantillonnage, et
         la valeur d'état correspondant au $i^{\text{ème}}$ groupe.

2. Système selon la revendication 1, dans lequel :

   le filtre numérique IIR est mis en œuvre à travers un pipeline ayant trois étages ;
   un premier étage du pipeline est configuré pour effectuer un traitement préliminaire sur les valeurs qui se situent dans le signal d'entrée et qui correspondent respectivement aux points d'échantillonnage dans le $i^{\text{ème}}$ groupe ;
   un deuxième étage du pipeline est configuré pour calculer une moyenne des valeurs qui se situent dans le signal d'entrée et qui correspondent respectivement aux points d'échantillonnage dans le $i^{\text{ème}}$ groupe selon un résultat du traitement du premier étage du pipeline, et pour calculer la valeur d'état correspondant au $i^{\text{ème}}$ groupe selon la moyenne et la valeur d'état correspondant au $(i\text{-}1)^{\text{ème}}$ groupe ; et
   un troisième étage du pipeline est configuré pour calculer le signal de sortie qui se situe dans le signal de sortie et qui correspond à chaque point d'échantillonnage dans le $i^{\text{ème}}$ groupe selon :

      la valeur qui se situe dans le signal d'entrée et qui correspond audit point d'échantillonnage, et
      la valeur d'état correspondant au $i^{\text{ème}}$ groupe.

3. Système selon la revendication 1 ou 2, dans lequel chaque groupe de points d'échantillonnage comprend k points d'échantillonnage, et k est un nombre entier supérieur à 1.

4. Système selon l'une des revendications 1 à 3, dans lequel chaque groupe de points d'échantillonnage comprend des points d'échantillonnage dont une quantité varie de 5 à 10.

5. Système de commande de signal selon l'une des revendications 1 à 4, dans lequel le circuit d'étalonnage de forme d'onde (12) est un réseau de portes programmables sur site, FPGA.

6. Système de commande de signal selon la revendication 5, dans lequel le FPGA a huit canaux, chacun d'entre eux comprenant au plus quatre filtres numériques IIR.

**7.** Circuit d'étalonnage de forme d'onde, comprenant au moins un filtre numérique à réponse impulsionnelle infinie, IIR, dans lequel :

le filtre numérique IIR est configuré pour étalonner une forme d'onde d'un signal d'entrée afin d'obtenir un signal de sortie, dans lequel le filtre numérique IIR calcule le signal de sortie selon le signal d'entrée et une valeur d'état du filtre numérique IIR ; et
la valeur d'état du filtre numérique IIR est mise à jour chaque fois qu'un groupe de points d'échantillonnage est échantillonné, et
chaque groupe de points d'échantillonnage comprend une pluralité de points d'échantillonnage ;
**caractérisé en ce que** le filtre numérique IIR est configuré pour :
calculer une valeur d'état correspondant au $i^{ème}$ groupe de points d'échantillonnage selon :

une moyenne des valeurs qui se situent dans le signal d'entrée et qui correspondent respectivement aux points d'échantillonnage dans le $i^{ème}$ groupe, et
une valeur d'état correspondant au $(i-1)^{ème}$ groupe de points d'échantillonnage, où i est un entier positif, et
calculer une valeur qui se situe dans le signal de sortie et qui correspond à chaque point d'échantillonnage dans le $i^{ème}$ groupe selon :

une valeur qui se situe dans le signal d'entrée et qui correspond audit point d'échantillonnage, et
la valeur d'état correspondant au $i^{ème}$ groupe.

**8.** Circuit d'étalonnage de forme d'onde selon la revendication 7, dans lequel :

le filtre numérique IIR est mis en œuvre à travers un pipeline ayant trois étages ;
un premier étage du pipeline est configuré pour effectuer un traitement préliminaire sur les valeurs qui se situent dans le signal d'entrée et qui correspondent respectivement aux points d'échantillonnage dans le $i^{ème}$ groupe ;
un deuxième étage du pipeline est configuré pour calculer une moyenne des valeurs qui se situent dans le signal d'entrée et qui correspondent respectivement aux points d'échantillonnage dans le $i^{ème}$ groupe selon un résultat du traitement du premier étage du pipeline, et pour calculer la valeur d'état correspondant au $i^{ème}$ groupe selon la moyenne et la valeur d'état correspondant au $(i-1)^{ème}$ groupe ; et
un troisième étage du pipeline est configuré pour calculer le signal de sortie qui se situe dans le signal de sortie et qui correspond à chaque point d'échantillonnage dans le $i^{ème}$ groupe selon :

la valeur qui se situe dans le signal d'entrée et qui correspond audit point d'échantillonnage, et
la valeur d'état correspondant au $i^{ème}$ groupe.

**9.** Circuit d'étalonnage de forme d'onde selon la revendication 7 ou 8, dans lequel chaque groupe de points d'échantillonnage comprend k points d'échantillonnage, et k est un nombre entier supérieur à 1.

**10.** Procédé pour commander un signal pour le calcul quantique, applicable à un système pour commander un signal pour le calcul quantique, dans lequel le système comprend une source de signal, un circuit d'étalonnage de forme d'onde, une ligne de commande de bit quantique et un module de bit quantique, et le procédé comprend les étapes suivantes :

générer (701) un signal de commande d'origine par la source de signal ;
étalonner (702), par le circuit d'étalonnage de forme d'onde, une forme d'onde du signal de commande d'origine à travers au moins un filtre numérique IIR dans le circuit d'étalonnage de forme d'onde afin d'obtenir un signal de commande étalonné ;
acheminer (703), par la ligne de commande de bit quantique, le signal de commande étalonné vers module de bit quantique ; et
générer (704) un bit quantique par le module de bit quantique ;
dans lequel le signal de commande étalonné est appliqué au bit quantique après avoir traversé la ligne de commande de bit quantique, et est configuré pour commander le bit quantique ;
dans lequel le filtre numérique IIR est configuré pour calculer un signal de sortie du filtre numérique IIR selon un signal d'entrée du filtre numérique IIR et une valeur d'état du filtre numérique IIR, dans lequel le signal d'entrée est le signal de sortie d'origine ou un signal de commande d'origine filtré par un ou plusieurs autres filtres numériques IIR,
et la valeur d'état du filtre numérique IIR est mise à jour chaque fois qu'un groupe de points d'échantillonnage est échantillonné, et chaque groupe de points d'échantillonnage comprend une pluralité de points d'échantillonnage ;
dans lequel le filtre numérique IIR est configuré pour :
calculer la valeur d'état correspondant au $i^{ème}$ groupe de points d'échantillonnage selon :

une moyenne des valeurs qui se situent dans le signal d'entrée et qui correspondent respectivement aux points d'échantillonnage dans le $i^{ème}$ groupe, et
la valeur d'état correspondant au $(i-1)^{ème}$ groupe de points d'échantillonnage, où i est un entier positif, et
calculer une valeur qui se situe dans le signal de sortie et qui correspond à chaque point d'échantillonnage dans le $i^{ème}$ groupe selon :

une valeur qui se situe dans le signal d'entrée et qui correspond audit point d'échantillonnage, et
la valeur d'état correspondant au $i^{ème}$ groupe.

**11.** Support de stockage lisible par ordinateur stockant au moins une instruction, au moins un programme, un ensemble de codes ou un ensemble d'instructions, dans lequel :
l'au moins une instruction, l'au moins un programme, l'ensemble de codes ou l'ensemble d'instructions, lorsqu'il est chargé et exécuté par un processeur d'un dispositif informatique, permet au dispositif informatique de mettre en œuvre le procédé selon la revendication 10.

**12.** Produit de programme informatique comprenant au moins une instruction, au moins un programme, un ensemble de codes ou un ensemble d'instructions, dans lequel :
l'au moins une instruction, l'au moins un programme, l'ensemble de codes ou l'ensemble d'instructions, lorsqu'il est chargé et exécuté par un processeur d'un dispositif informatique, permet au dispositif informatique de mettre en œuvre le procédé selon la revendication 10.

System for controlling signal in quantum computing

Signal source — 11

Original control signal →

Waveform calibration circuit (including at least one IIR digital filter) — 12

Calibrated control signal →

Qubit control line — 13

Control signal applied to the qubit →

Qubit module — 14

Control signal applied to the qubit →

Qubit — 15

Figure 1

FIG. 2

Figure 3

Figure 4

Figure 5

Figure 6

A signal source generates an original control signal — 701

A waveform calibration circuit calibrates a waveform of the original control signal, through at least one IIR digital filter in the waveform calibration circuit, to obtain a calibrated control signal — 702

A qubit control line conveys the calibrated control signal to a qubit module — 703

The qubit module generates a qubit, where the calibrated control signal is applied on the qubit after passing the qubit control line and is configured to control the qubit — 704

Figure 7

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202110988046

**Non-patent literature cited in the description**

- **M. A. ROL et al.** Time-domain characterization and correction of on-chip distortion of control pulses in a quantum processor. *Appl. Phys. Lett.*, 2020, vol. 116, 054001

- An FPGA-Based Low Latency AWG for Superconducting Quantum Computers. **YUCHEN YANG et al.** 2021 IEEE INTERNATIONAL INSTRUMENTATION AND MEASUREMENT TECHNOLOGY CONFERENCE (I2MTC). IEEE, 17 May 2021, 1-6